(19) Europäisches Patentamt

European Patent Office

Office européen des brevets

(11) **EP 3 123 187 B1**

(12) **FASCICULE DE BREVET EUROPEEN**

(45) Date de publication et mention de la délivrance du brevet:
**13.10.2021 Bulletin 2021/41**

(21) Numéro de dépôt: **15712121.1**

(22) Date de dépôt: **24.03.2015**

(51) Int Cl.:
*G01R 31/62* (2020.01)     *G01R 31/40* (2020.01)

(86) Numéro de dépôt international:
**PCT/EP2015/056194**

(87) Numéro de publication internationale:
**WO 2015/144666 (01.10.2015 Gazette 2015/39)**

(54) **PROCÉDÉ DE TEST D'UN TRANSFORMATEUR, SYSTEME ÉLECTRIQUE DE TEST, CIRCUIT DE COURT-CIRCUITAGE ET ENSEMBLE D'ANODISATION**

**VERFAHREN ZUM TESTEN EINES TRANSFORMATORS, ELEKTRISCHES TESTSYSTEM, KURZSCHLIESSSCHALTUNG UND ANODISIERENDE ANORDNUNG**

**METHOD OF TESTING A TRANSFORMER, ELECTRICAL TESTING SYSTEM, SHORT-CIRCUITING CIRCUIT AND ANODIZING ASSEMBLY**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.03.2014 FR 1452678**

(43) Date de publication de la demande:
**01.02.2017 Bulletin 2017/05**

(73) Titulaire: **General Electric Technology GmbH 5400 Baden (CH)**

(72) Inventeurs:
• **MARNAY, David**
  **F-91400 Orsay (FR)**

• **LOUISE, Sébastien**
  **F-94600 Choisy Le Roi (FR)**
• **TIRILLY, Serge**
  **F-91300 Massy (FR)**
• **NGNEGUEU, Triomphant**
  **F-92310 Sèvres (FR)**

(74) Mandataire: **Brevalex**
  **95, rue d'Amsterdam**
  **75378 Paris Cedex 8 (FR)**

(56) Documents cités:
  **FR-A1- 2 970 109     GB-A- 943 203**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE**

La présente invention concerne un transformateur pour circuit redresseur de forte puissance utilisable notamment pour alimenter en courant continu une installation telle qu'une installation comportant des cuves d'électrolyse d'aluminium.

**ÉTAT DE LA TECHNIQUE ANTÉRIEURE**

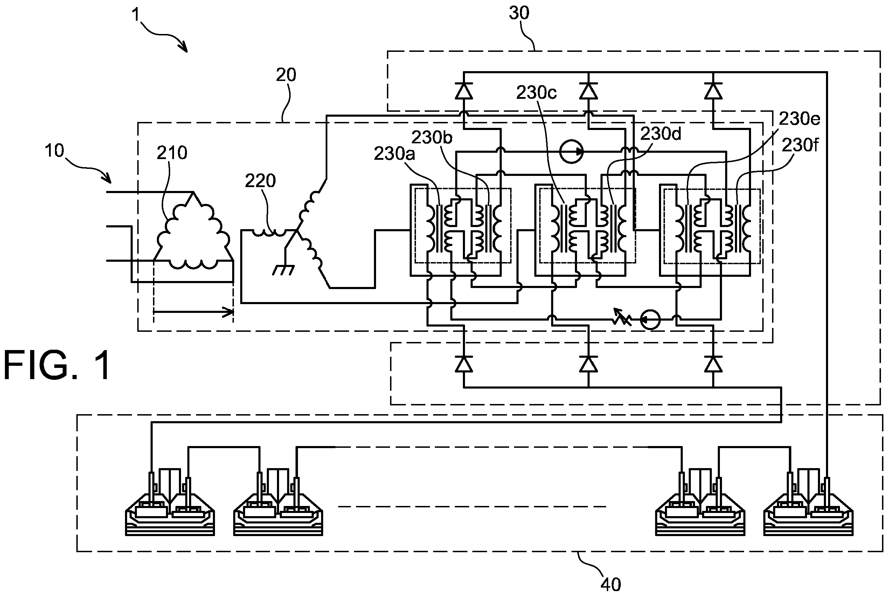

En référence à la figure 1, un transformateur 20 pour circuit redresseur, ci-après transformateur de redresseur, est généralement destiné à être installé à l'interface entre un circuit d'alimentation 10 comportant au moins une phase, et une installation 40, telle qu'une installation comportant des cuves d'électrolyse d'aluminium. La figure 1 illustre un tel transformateur de redresseur 20 lorsqu'il est installé à l'interface entre un circuit d'alimentation 10 électrique comportant trois phases et une installation 40 de cuves d'électrolyse.

Un tel transformateur de redresseur 20 comporte, pour chacune des phases, deux bobinages, un primaire 210 et un secondaire 220, ces bobinages 210, 220 pouvant être montés par exemple en triangle ou en étoile, comme c'est le cas sur la figure 1. Chacun des bobinages primaires 210 est relié à la phase correspondante du circuit d'alimentation 10, tandis que les bobinages secondaires 220 comportent chacun une branche positive et une banche négative reliées à l'installation 40 au travers d'un circuit redresseur 30 de manière à alimenter ladite installation en courant continue.

Chacune des branches positive et négative comporte un transducteur magnétique 230a,b,c,d,e,f. Un tel transducteur magnétique 230a,b,c,d,e,f est un dispositif à l'aide duquel on peut faire varier la tension continue en sortie du circuit redresseur 30 par l'intermédiaire d'un courant indépendant, en utilisant les phénomènes de saturation du circuit magnétique. Ces transducteurs magnétiques 230a,b,c,d,e,f permettent ainsi de faire varier très rapidement la tension continue de sortie mais avec une amplitude limitée. Le brevet français n°2970109 déposé le 30 décembre 2010 fournit une description complète de la structure et du fonctionnement de ces transducteurs magnétiques 230a,b,c,d,e,f.

Ainsi, un tel transducteur magnétique 230a,b, c,d,e,f comporte un ensemble de barres conductrices. Cet ensemble est destiné à être monté entre un enroulement secondaire du transformateur et une borne de raccordement de sortie positive ou négative destinée à être reliée à un bras positif ou négatif du circuit redresseur 30. Un ou plusieurs tores magnétiques sont enfilés autour de l'ensemble de barres conductrices. Le transducteur magnétique 230a,b,c,d,e,f comporte de plus un ou plusieurs circuits électriques dont un circuit électrique de commande pour assurer le réglage de la tension continue. Sur chaque transducteur ce circuit électrique de commande prend la forme d'au moins une boucle ou spire conductrice de commande qui ceinture l'ensemble des tores formant le circuit magnétique du transducteur. On fait ainsi circuler dans ces circuits des courants continus ajustables pour régler la tension continue.

Or, de tels transducteurs magnétiques 230a,b, c,d,e,f perturbent les mesures de court-circuit pourtant requises par la norme CEI 60076-1 et il reste nécessaire de définir un procédé de mesure satisfaisant permettant de répondre à la norme CEI 60076-1.

En effet, s'il est bien fait mention de deux méthodes de mesures dans l'annexe F de la norme CEI 61378-1 dans sa deuxième édition, ces méthodes restent insuffisantes.

La première méthode consiste à mettre en place un banc de capacités au dimensionnement adapté pour compenser la puissance réactive supplémentaire induite par la présence des tores des transducteurs magnétiques et à utiliser un système de mesure pour déterminer les composantes harmoniques en courant et en tension qui découlent de la présence des tores des transducteurs 230a,b,c,d,e,f.

Avec une telle première méthode, il est possible de compenser les effets harmoniques liés à la présence des tores des transducteurs magnétiques et donc de corriger les valeurs d'impédance et de pertes en court-circuit du transformateur de redresseur 20 mesurées. Néanmoins, cette méthode ne permet pas de pleinement répondre aux prescriptions de la norme CEI 60076-1 puisque la mesure n'est pas effectuée à la fréquence assignée sous tension pratiquement sinusoïdale.

La deuxième méthode nécessite que tous les transformateurs 20 à mesurer soient préalablement contrôlés en impédance et en perte à sec, c'est-à-dire hors de la cuve d'isolation qui contient un fluide diélectrique. Ensuite, seul un transformateur est monté dans sa cuve sans qu'il soit relié à ses transducteurs magnétiques 230a,b,c,d,e,f ceci de manière à réaliser les essais en court-circuit conformément aux prescriptions de la norme CEI 60076-1. Les différences d'impédance et de pertes vis-à-vis du même transformateur de redresseur hors cuve sont alors ajoutées aux valeurs d'impédance et de pertes de chacun des autres transformateurs de redresseur 20 déterminées à sec.

Ainsi, si de telles mesures à sec corrigées par la mesure sur un transformateur de référence permettent de répondre aux prescriptions de la norme CEI 60076-1, elles présentent toutefois un certain nombre d'inconvénients. En effet, les mesures à sec systématiques sur les transformateurs peuvent en perturber le bon fonctionnement et sont donc à éviter. De plus, elles sont relativement lourdes et coûteuses à mettre en place, notamment en ce qui concerne le transformateur de référence mesuré en cuve puisque ce dernier doit être ensuite vidé de son huile et décuvé ceci de manière à permettre le montage des transducteurs mangnétiques 230a,b,c,d,e,f.

Pour résoudre les inconvénients rencontrés avec ces deux méthodes, il est connu du brevet français n°2970109 déposé le 30 décembre 2010 de modifier l'arrangement des transducteurs magnétiques. En effet, il est proposé, dans ce brevet, d'utiliser un tore magnétique commun pour les transducteurs magnétiques 230a,b,c, d,e,f des branches positive et négative d'un même bobinage secondaire. Ainsi, lors de la mise en court-circuit du circuit secondaire du transformateur de redresseur, les branches positives et négatives étant mises en court-circuit, le courant passant dans le transducteur magnétique de la branche positive est compensé par un courant de signe inverse passant dans la branche négative. Il en résulte que dans cette configuration, pour chaque tore magnétique, le champ magnétique créé par le courant dans la branche positive est compensé par celui créé par le courant transitant dans la branche négative.

Une telle configuration permet donc de réaliser les mesures en court-circuit prescrites par la norme CEI 60076-1, sans perturbation liée aux effets harmoniques que pourrait engendrer la présence des transducteurs magnétiques. Néanmoins, une telle configuration présente des inconvénients concernant les possibilités de commande en tension autorisées par les transducteurs magnétiques 230a,b,c,d,e,f. En effet, avec une telle configuration, il n'est pas possible d'utiliser la commande en tension permise par les transducteurs magnétiques 230a,b,c,d,e,f lorsque le transformateur de redresseur est utilisé pour alimenter une installation fonctionnant partiellement (c'est-à-dire comportant un nombre réduit de cuves d'électrolyse reliées au transformateur de redresseur 20).

**EXPOSÉ DE L'INVENTION**

L'un des buts de l'invention est de fournir un procédé de mesure qui permette sur un transformateur comportant des transducteurs magnétiques classiques, c'est-à-dire comportant chacun un tore magnétique dédié, d'effectuer les mesures en court-circuit prescrites par la norme CEI 60076-1 sous tension sinusoïdale et sans nécessiter d'effectuer de mesures à sec dudit transformateur.

A cet effet l'invention concerne un procédé de test d'un transformateur, dit de redresseur, destiné à être installé à l'interface entre un circuit d'alimentation comportant au moins une phase, et une installation, telle qu'une installation comportant des cuves d'électrolyse d'aluminium, le transformateur de redresseur comportant pour chaque phase du circuit d'alimentation un bobinage primaire destiné à être relié à la phase correspondante du circuit d'alimentation et un bobinage secondaire destiné à être relié au travers d'un circuit redresseur à l'installation par une branche positive et une branche négative, chacune des branches positive et négative étant équipée d'un transducteur magnétique, le procédé comportant les étapes consistant à :

- court-circuiter chaque branche positive avec la branche négative correspondante de manière à n'autoriser le parcours du courant entre une branche positive et une branche négative que dans un sens, ceci afin de mettre en saturation magnétique les transducteurs magnétiques desdites branches positive et négative lors d'une mesure d'impédance,

- effectuer une mesure d'impédance et/ou de pertes du transformateur de redresseur, les transducteurs magnétiques du transformateur étant en saturation magnétique grâce au court-circuitage.

De cette manière lors de l'étape de mesure d'impédance et/ou de pertes, le courant ne parcourt chacun des transducteurs magnétiques que dans un sens, et il en résulte que chacun des tores magnétiques de ces transducteurs magnétiques est soumis à un champ magnétique généré par le courant dont le sens ne varie pas dans le temps. Le champ magnétique ne changeant pas de sens dans le temps, les tores magnétiques restent dans le même état magnétique et les transducteurs se trouvent ainsi dans un état d'autosaturation. Dans cet état d'auto-saturation, les effets non linéaires et harmoniques présents lors d'une mesure en court-circuit sont fortement réduits puisque les tores magnétiques restent dans le même état magnétique.

Ainsi, avec un tel procédé de mesure d'impédance et/ou de pertes, il est possible d'effectuer une mesure en court-circuit, telle que prescrite par la norme CEI 60076-1, sans perturbation significative liée à la présence des transducteurs mangnétiques.

Le transformateur de redresseur peut être destiné à être installé à l'interface entre un circuit d'alimentation comportant au moins deux phases, et une installation,

et lors de l'étape de court-circuitage, l'ensemble des branches positives peut être mis en court-circuit avec des branches négatives.

Il est à noter que dans la configuration préférentielle de l'invention, le transformateur de redresseur est destiné à être installé à l'interface entre un circuit d'alimentation comportant trois phases, donc dans la configuration au moins deux phases explicitée ci-dessus, et une installation, lors de l'étage de court-circuitage l'ensemble des branches positives est donc préférentiellement court-circuité avec des branches négatives.

Il peut être mis en œuvre un moyen de court-circuitage et un moyen de mesure, l'étape de mesure d'impédance comportant alors les sous-étapes suivantes consistant à :

- effectuer un étalonnage préalable des moyens de court-circuitage et de mesure de manière à déterminer des valeurs d'étalonnage desdits moyens de court-circuitage et de mesure,
- effectuer une mesure d'impédance et/ou de pertes, ceci avec le moyen de mesure,
- compenser la mesure d'impédance et/ou de pertes à partir des valeurs d'étalonnage des moyens de court-circuitage et de mesure, ceci de manière à déterminer les valeurs d'impédance et/ou de pertes du transformateur de redresseur.

Avec une telle étape d'étalonnage préalable, il est possible de fournir des valeurs d'impédance et de pertes du transformateur de redresseur sans influence du moyen de court-circuitage ou du moyen de mesure utilisé.

Le transformateur de redresseur peut être installé à l'interface entre un circuit d'alimentation comportant au moins une phase, et une installation, l'étape de court-circuitage du transformateur de redresseur consistant à court-circuiter le circuit redresseur à travers lequel le transformateur de redresseur est relié à l'installation, ceci de manière à n'autoriser le parcours du courant entre chaque branche positive et la branche négative correspondante que dans un sens.

Avec une telle installation du transformateur de redresseur, il est possible d'effectuer le test en court-circuitage selon la norme CEI 60076-1 sur le site sur lequel est installé le transformateur de redresseur et il également possible, avec un nombre d'opérations réduit, d'effectuer régulièrement le test en court-circuitage pendant toute la durée de fonctionnement du transformateur de redresseur.

L'invention concerne en outre un système électrique de test comportant un transformateur, dit de redresseur, à tester, le transformateur de redresseur étant destiné à être installé à l'interface entre un circuit d'alimentation comportant au moins une phase, et une installation, telle qu'une installation comportant des cuves d'électrolyse d'aluminium, le transformateur de redresseur comportant pour chaque phase du circuit d'alimentation un bobinage primaire destiné à être relié à la phase correspondante du circuit d'alimentation et un bobinage secondaire destiné à être relié au travers d'un circuit redresseur à l'installation par une branche positive et une branche négative, chacune des branches positive et négative étant équipée d'un transducteur magnétique, le système électrique comportant :

- un moyen de court-circuitage agencé pour court-circuiter chaque branche positive avec la branche négative correspondante de manière à n'autoriser le parcours du courant entre une branche positive et une branche négative que dans un sens, ceci afin de mettre en saturation magnétique les transducteurs magnétiques desdites branches positive et négative lors d'une mesure d'impédance, et
- un moyen de mesure d'impédance adapté pour effectuer une mesure d'impédance du transformateur de redresseur, les transducteurs magnétiques du transformateur de redresseur étant en saturation magnétique grâce au court-circuitage.

Un tel système de test permet de tester le transformateur de redresseur comportant des transducteurs magnétiques classiques, c'est-à-dire comportant chacun un tore magnétique dédié, en effectuant les mesures en court-circuit prescrites par la norme CEI 60076-1 sous tension sinusoïdale et sans nécessiter d'effectuer de mesure à sec dudit transformateur.

Le moyen de court-circuitage peut comporter un circuit de court-circuitage comportant pour chaque branche positive une branche de court-circuitage reliant ladite branche positive à la branche négative correspondante, chaque branche de court-circuitage comportant au moins une diode dite positive associée à la branche positive pour n'autoriser le parcours du courant dans ladite branche de court-circuitage que dans un sens.

Le transformateur de redresseur peut être destiné à être installé à l'interface entre un circuit d'alimentation comportant au moins deux phases, et une installation,
et chacune des branches de court-circuitage sont reliées entre elles de manière à mettre l'ensemble des branches positives en court-circuit avec l'ensemble des branches négatives, chacune des branches de court-circuitage comportant au moins une diode dite négative associée à une branche négative de manière à ce que la diode positive n'autorise le parcours du courant dans la branche positive correspondante que dans un sens et que la diode négative n'autorise le parcours du courant dans la branche négative correspondante dans le sens opposé que celui de la diode positive.

Le système électrique de test peut comporter en outre un circuit redresseur au travers duquel chaque bobinage secondaire du transformateur de redresseur est destiné à être relié à l'installation par une branche positive et une branche négative, ledit circuit de redresseur comportant au moins une configuration de court-circuitage dans laquelle il est agencé pour court-circuiter chaque branche positive avec la branche négative correspondante de manière à n'autoriser le parcours du courant entre une branche positive et une branche négative que dans un sens, ceci afin de mettre en saturation magnétique les transducteurs magnétiques desdites branches positive et négative lors d'une mesure d'impédance, ledit circuit de redresseur formant le moyen de court-circuitage.

L'invention concerne en outre un circuit de court-circuitage pour un transformateur , dit de redresseur, qui est destiné à être installé à l'interface entre un circuit d'alimentation comportant au moins une phase, et une installation, telle qu'une installation comportant des cuves d'électrolyse d'aluminium, le transformateur de redresseur comportant pour chaque phase du circuit d'alimentation un bobinage primaire destiné à être relié à la phase correspondante du circuit d'alimentation et un bobinage secondaire destiné à être relié au travers d'un circuit redresseur à l'installation par une branche positive et une branche négative, chacune des branches positive et négative étant équipée d'un transducteur magnétique, le circuit de court-circuitage comportant pour chaque branche positive une branche de court-circuitage reliant ladite branche positive à la branche négative correspondante, chaque branche de court-circuitage comportant au moins une diode dite positive destinée à être associée à la branche positive pour n'autoriser le parcours du courant dans ladite branche de court-circuitage que dans un sens.

Le circuit de court-circuitage peut être destiné au test d'un transformateur de redresseur destiné à être installé à l'interface entre un circuit d'alimentation comportant au moins deux phases et une installation, chacune des branches de court-circuitage du circuit de court-circuitage étant reliée entre elle de manière à mettre l'ensemble des branches positives en court-circuit avec l'ensemble des branches négatives, chacune des branches de court-circuitage comportant au moins une diode dite négative destinée à être associée à une branche négative du transformateur de redresseur de manière à ce que la diode positive n'autorise le parcours du courant dans la branche positive que dans un sens et que la diode négative n'autorise le parcours du courant dans la branche négative dans le sens opposé que celui de la diode positive.

L'invention concerne en outre un ensemble d'anodisation comportant une installation d'anodisation d'aluminium, un circuit d'alimentation alternatif, un transformateur dit de redresseur, et un circuit redresseur, ledit transformateur de redresseur étant installé à l'interface entre le circuit d'alimentation et de l'installation, le transformateur de redresseur comportant pour chaque phase du circuit d'alimentation un bobinage primaire relié à la phase correspondante du circuit d'alimentation et un bobinage secondaire relié au travers du circuit redresseur à l'installation par une branche positive et une branche négative, chacune des branches positive et négative étant équipée d'un transducteur magnétique, le circuit redresseur présentant une configuration dans laquelle il comporte pour chaque branche positive une branche de court-circuitage reliant ladite branche positive à la branche négative correspondante, chaque branche de court-circuitage étant configurée pour n'autoriser le parcours du courant dans ladite branche de court-circuitage que dans un sens.

**BRÈVE DESCRIPTION DES DESSINS**

La présente invention sera mieux comprise à la lecture de la description d'exemples de réalisation, donnés à titre purement indicatif et nullement limitatif, en faisant référence aux dessins annexés sur lesquels :

- la figure 1 illustre un exemple d'ensemble d'anodisation comportant une installation d'anodisation d'aluminium, un circuit d'alimentation alternatif et un système d'interface comprenant un transformateur de redresseur et un circuit redresseur installés à l'interface entre l'installation et le circuit d'alimentation,
- la figure 2 illustre un exemple de système électrique de test d'un transformateur de redresseur tel que compris dans l'ensemble d'anodisation de la figure 1,

- la figure 3 illustre la variation de la configuration magnétique d'un tore magnétique d'un transducteur magnétique tel que compris dans l'ensemble d'anodisation de la figure 1, ceci en fonction du champ magnétique appliqué audit tore magnétique pour trois configurations du transformateur de redresseur dont la configuration de fonctionnement, courbe référencée 801, une configuration de court-circuit simple du transformateur de redresseur, courbe référencée 802 et une configuration de test selon l'invention référencée 803,

- la figure 4 illustre le courant circulant dans la barre de cuivre d'un transducteur lors de la mise en œuvre du système électrique de test illustré sur la figure 2,
- la figure 5 illustre un schéma équivalent de la répartition des impédances dans un système électrique de test tel qu'illustré sur la figure 2,
- la figure 6 illustre un système électrique de test selon une possibilité envisageable de l'invention,
- la figure 7 illustre un ensemble d'anodisation présentant une configuration adaptée pour former un système électrique de test selon un troisième mode de réalisation de l'invention
- les figures 8A à 8D illustrent des systèmes électriques de test selon des variantes de configurations à celle du système électrique de test illustré sur la figure 2.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

La figure 1 illustre un ensemble d'anodisation 1 classique tel que présent dans l'art antérieur et déjà décrit dans l'exposé de l'art antérieur. Il est néanmoins à noter que dans l'exemple exposé sur la figure 1, si l'installation 40 est une installation d'anodisation d'aluminium comportant une pluralité de cuves d'électrolyse d'aluminium, l'invention ne se limite pas à cette seule application et concerne plus généralement les procédés de test en court-circuit de transformateurs comportant des transducteurs magnétiques quelle que soit l'installation à alimenter.

Un tel ensemble d'anodisation 1 comporte notamment un transformateur 20 dit de redresseur qui est installé à l'interface entre l'installation 40 et le circuit d'alimentation 30. Le transformateur de redresseur 20 comporte pour chacune des phases du circuit d'alimentation 210 :

- un bobinage primaire 210 relié à la phase correspondante du circuit d'alimentation,
- un bobinage secondaire 220 comportant une branche positive et une branche négative,
- un groupe de deux transducteurs magnétiques 230a,b,c,d,e,f, un transducteur magnétique 230b,d, f étant relié à la branche positive du bobinage secondaire 220 tandis que l'autre transducteur 230a, c,e est relié à la branche négative 220.

De manière à alimenter l'installation 40 avec une tension sensiblement continue, le transformateur de redresseur 20 est relié à l'installation 40 au travers d'un circuit redresseur 30. Le circuit redresseur 30, illustré sur la figure 1, est du type pont de Graëtz à diodes.

Ainsi, les transducteurs magnétiques 230b,d,f des branches positives du transformateur de redresseur 20 sont reliés à une borne d'alimentation positive de l'installation 40, chacun au moyen d'une diode dédiée. Dans cette configuration du circuit redresseur 30 du type pont de Graëtz à diodes, l'anode de la diode est reliée au transducteur magnétique 230b,d,f de la branche positive, la cathode étant reliée à la borne positive d'alimentation de l'installation 40.

De même, les transducteurs magnétiques des branches négatives 230a,c,e du transformateur de redresseur 20 sont reliés à une borne négative de l'installation 40, chacun au moyen d'une diode dédiée. Dans cette configuration d'un circuit redresseur 30 du type pont de Graëtz à diodes, la cathode de chaque diode est reliée au transducteur magnétique 230a,c,e de la branche positive correspondante, l'anode étant reliée à la borne négative d'alimentation de l'installation 40.

Avec un tel ensemble, il est possible d'alimenter l'installation 40 en courant sensiblement continu de forte puissance et de basse tension, ceci à partir d'un circuit d'alimentation triphasé alternatif.

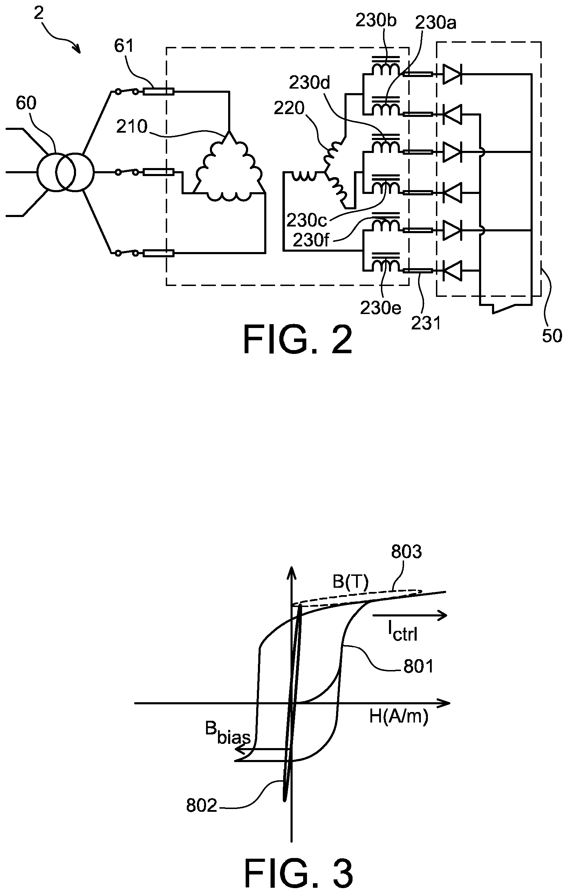

La figure 2 illustre un système électrique de test 2 selon un premier mode de réalisation de l'invention pour tester en court-circuit un transformateur de redresseur 20 installé, ou destiné à être installé dans un ensemble d'anodisation 1 selon la figure 1. Ce système de test permet de réaliser un test en court-circuit tel que préconisé par la norme CEI 60076-1.

Un tel système électrique de test 2 comporte, outre le transformateur de redresseur 20 à tester, un circuit de court-circuitage 50 du transformateur de redresseur et un transformateur de test 60 adapté pour alimenter le transformateur de redresseur avec une tension triphasée alternative.

Le circuit de court-circuitage 50 est agencé pour court-circuiter chaque branche positive avec la branche négative correspondante, ceci de manière à n'autoriser le parcours du courant entre une branche positive et une branche négative que dans un sens de manière à mettre en saturation magnétique les transducteurs magnétiques desdites branches positive et négative lors d'une mesure d'impédance et/ou de pertes. Un tel agencement du circuit de court-circuitage 50 peut être obtenu, comme illustré sur la figure 2, par un circuit redresseur reliant les branches positives avec les branches négatives. Un tel circuit de court-circuitage 50 comporte ainsi, pour chacune des branches, une diode de manière à n'autoriser le parcours du courant entre les branches positives et les branches négatives que dans un sens.

Ainsi, dans la configuration illustrée sur la figure 2, dans laquelle le circuit de court-circuitage 50 est un redresseur du type pont de Graëtz, ce dernier comporte pour chaque branche positive une branche de court-circuitage reliant ladite branche positive à la branche négative correspondante, chaque branche de court-circuitage comportant au moins une diode dite positive associée à la branche positive pour n'autoriser le parcours du courant dans ladite branche de court-circuitage que dans un sens.

Dans cette configuration du circuit de court-circuitage, les branches de court-circuitage sont reliées entre elles de manière à mettre l'ensemble des branches positives en court-circuit avec l'ensemble des branches négatives. Chacune des branches de court-circuitage comporte également au moins une diode dite négative associée à la branche négative de manière à ce que la diode positive n'autorise le parcours du courant dans la branche positive que dans un sens et que la diode négative n'autorise le parcours du courant dans la branche négative que dans le sens opposé de celui de la diode positive.

Ainsi dans la configuration illustrée sur la figure 2, les diodes positives sont reliées à la branche positive correspondante du transformateur de redresseur 20 par leur anode tandis que les diodes négatives sont reliées à la branche négative correspondante du transformateur de redresseur 20 par leur cathode. Ainsi, les diodes positives n'autorisent le parcours du courant que dans le sens bobinage secondaire vers branche négative tandis que les diodes négatives n'autorisent le parcours du courant que dans le sens branche négative vers bobinage secondaire. Dans cette configuration, le courant peut parcourir le transformateur de redresseur uniquement dans le sens allant de la branche positive vers la branche négative, les diodes étant bloquées dans le sens inverse.

Avec un tel circuit de court-circuitage 50, lorsque le transformateur de test 60 alimente le transformateur de redresseur 20 avec une tension triphasée alternative, chacun des transducteurs magnétiques 230a,b, c,d,e,f, en raison du circuit de court-circuitage 50, est parcouru par un courant de signe continu et est donc en saturation magnétique.

Dans un tel système électrique de test 2, le circuit de court-circuitage 50 forme un moyen de court-circuitage agencé pour court-circuiter chaque branche positive avec la branche négative correspondante de manière à n'autoriser le parcours du courant entre une branche positive et une branche négative que dans un sens, ceci afin de mettre en saturation magnétique les transducteurs magnétiques desdites branches positive et négative lors d'une mesure d'impédance et/ou de pertes. De même, le transformateur de test 60 avec un système de mesure d'impédance, non illustré, forme un moyen de mesure d'impédance et/ou de pertes adapté pour effectuer une mesure d'impédance du transformateur de redresseur 20, les transducteurs magnétiques 230a,b,c, d,e,f du transformateur de redresseur 20 étant en saturation magnétique grâce au court-circuitage.

La figure 3 permet d'illustrer ce phénomène de saturation des transducteurs magnétiques 230a,b,c,d,e, f. En effet, la figure 3 représente la configuration magnétique du tore d'un transducteur magnétique 230a,b,c,d, e,f en fonction de l'excitation magnétique perçue par ce dernier, ceci lors de trois configurations différentes du transformateur de redresseur 20 : en utilisation, le transformateur de redresseur 20 étant installé à l'interface entre un circuit d'alimentation 10 et une installation 40 ; en court-circuit, le transformateur de redresseur 20 étant alimenté par une tension alternative triphasée ; et en court-circuit au moyen du circuit de court-circuitage illustré sur la figure 2, le transformateur de redresseur 20 étant également alimenté par une tension alternative triphasée.

On peut ainsi voir que, dans la première configuration, qui est celle du transformateur de redresseur 20 en configuration de fonctionnement, représentée par la courbe 801, il se crée un cycle d'hystérésis avec de fortes variations d'impédance qui génèrent des harmoniques de courant et de tension. Dans la deuxième configuration, correspondant à un court-circuit classique du transformateur de redresseur 20, la courbe 802 ne montre pas de phénomène d'hystérésis et le tore magnétique présente une variation forte de sa configuration magnétique. Une telle variation de la configuration magnétique du tore magnétique génère également des harmoniques de courant et de tension qui ne sont pas compatibles avec les mesures selon les prescriptions de la norme CEI 60076-1. Dans la troisième configuration, qui est celle selon l'invention, le tore magnétique n'étant soumis qu'à un champ magnétique dont le signe est constant, sa configuration magnétique reste relativement constante. Il en résulte que l'impédance du transducteur magnétique 230a,b,c,d,e,f, lorsque le courant le parcourant est suffisant, est sensiblement constante.

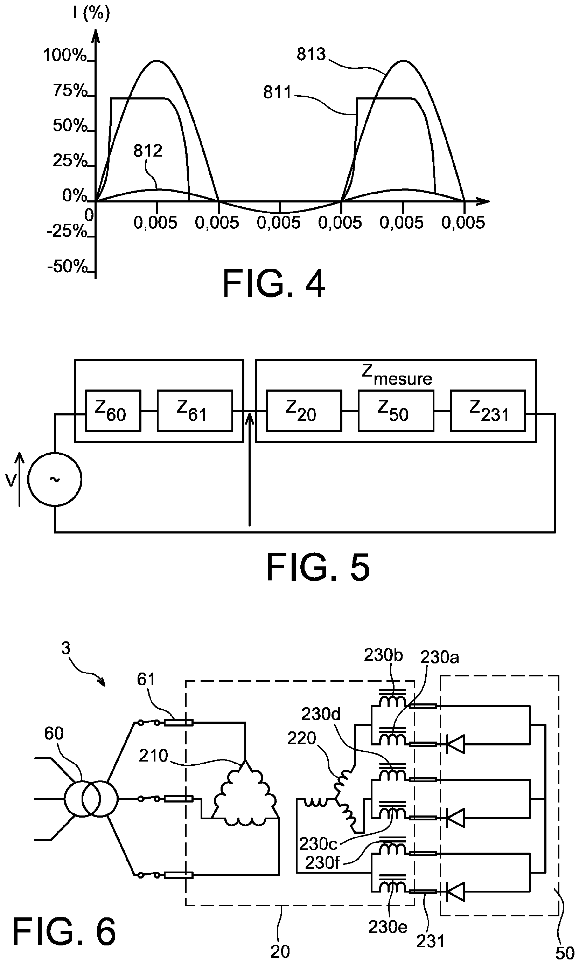

La figure 4 illustre également ce phénomène en montrant le courant transitant dans un transducteur magnétique 230a,b,c,d,e,f dans ces mêmes trois configurations du transformateur de redresseur 20.

Ainsi, dans la première configuration, c'est-à-dire le transformateur de redresseur 20 en fonctionnement, le courant présente, comme le montre la courbe 811, des variations harmoniques marquées. Dans la deuxième configuration, le transducteur magnétique 230a,b,c,d,e,f comporte, en raison des variations de configuration magnétique observées sur la figure 3, une impédance très élevée comparativement à celle du reste du transformateur de redresseur 20 comme le montre la faible valeur de courant observée sur la courbe 812. Il est donc nécessaire, pour effectuer les mesures selon les prescriptions de la norme CEI 60076-1, de monter l'ensemble de test à des valeurs d'intensité élevées et le courant alors obtenu présente un contenu harmonique non conforme vis-à-vis des exigences de cette même norme.

Dans la troisième configuration, celle du système électrique de test selon l'invention, les tores magnétiques ne présentant pas de variation significative de leur état magnétique, il subsiste seulement une impédance résiduelle des transducteurs magnétiques 230a,b,c,d,e, f qui est sensiblement constante. Or, l'impédance du reste du transformateur de redresseur 20 augmente linéairement avec le courant appliqué. Ainsi, il est possible, avec une telle configuration et avec un courant de test suffisant, de déterminer l'impédance et les pertes liées au transformateur en lui-même sans influence significative, au sens de la norme CEI 60076-1, des transducteurs magnétiques 230a,b,c,d,e,f, notamment en ce qui concerne le taux d'harmonique.

La figure 5 illustre le principe du calcul d'impédance et de pertes avec un système électrique de test 2 selon l'invention en montrant un schéma équivalent de la répartition des impédances dans ce système de test. Ainsi, l'impédance mesurée est celle du transformateur de redresseur $Z20$ et du dispositif de court-circuitage $Z50$, $Z231$. Sur cette figure sont également représentées à titre d'illustration l'impédance $Z60$ du transformateur de test 60 et l'impédance $Z61$ du jeu de barre de test 61 reliant le transformateur de test 60 au transformateur d'alimentation 20.

Ainsi pour déterminer précisément l'impédance du transformateur de redresseur 20 sans l'influence des transducteurs magnétiques 230a,b,c,d,e,f avec la configuration illustrée sur la figure 2, il est possible d'utiliser l'équation suivante : $Z_{mesure}= Z20+Z50+Z231$ avec $Z20$ l'impédance du transformateur de redresseur 20, $Z50$ l'impédance du circuit de court-circuitage 50 et $Z231$ l'impédance du jeu de barres 231 reliant le transformateur de redresseur 20 au circuit de court-circuitage 50.

Ainsi, avec un système de test 2 préalablement calibré en impédance, l'impédance $Z20$ du transformateur de redresseur 20 peut être déterminée à partir de la mesure de l'impédance équivalente en suivant l'équation suivante :

$$Z20= Z_{mesure} -Z50-Z231.$$

Sur ce même principe, les pertes $P20$ du transformateur de redresseur 20 en court-circuit peuvent être déterminées avec un tel système électrique de test 2 à partir de l'équation suivante :
$P20= P_{mesure} -Z50-Z231$ avec $Z50$ les pertes liées au circuit de court-circuitage 50 et Z231 les pertes liées au jeu de barres 231 reliant le transformateur de redresseur 20 au circuit de court-circuitage 50.

Afin de répondre aux prescriptions de la norme CEI 60076-1, il est possible de déterminer à partir de l'impédance Z20 et des pertes P20 du transformateur de redresseur 20 ainsi obtenu, l'impédance et les pertes du transformateur de redresseur 20 en court-circuit sans influence significative des transducteurs magnétiques 230a,b,c,d,e,f. En effet, en fonction des conditions de mesure, il est possible, soit de négliger l'influence des transducteurs magnétiques 230a,b,c,d,e,f, ceux-ci étant en saturation magnétique pendant la mesure, soit d'utiliser le fait que la valeur d'impédance des transducteurs magnétiques 230a,b,c,d,e,f est sensiblement constante avec le courant alors que l'impédance du transformateur de redresseur 20 sans influence des transducteurs magnétiques 230a,b,c,d,e,f présente des variations d'impédance linéaires avec le courant.

Un tel système électrique de test 2 peut ainsi être mis en œuvre lors d'un procédé de test d'un transformateur de redresseur 20. Un tel procédé comporte les étapes consistant à :

- court-circuiter l'ensemble des branches positives en court-circuit avec l'ensemble des branches négatives de manière à n'autoriser le parcours du courant entre une branche positive et une branche négative que dans un sens, ceci afin de mettre en saturation magnétique les transducteurs magnétiques 230a,b,c,d,e,f desdites branches positive et négative lors d'une mesure d'impédance et/ou de pertes,
- effectuer une mesure d'impédance et/ou de pertes du transformateur de redresseur 20, les transducteurs magnétiques 230a,b,c,d,e,f du transformateur de redresseur 20 étant en saturation magnétique grâce au court-circuitage.

L'étape de mesure d'impédance peut comporter les sous-étapes suivantes :

- effectuer un étalonnage préalable du circuit de court-circuitage 50 et du transformateur de test 60 de manière à déterminer des valeurs d'étalonnage desdits moyens de court-circuitage et de mesure,
- effectuer une mesure d'impédance et/ou de pertes, ceci avec le moyen de mesure,
- compenser la mesure d'impédance et/ou de pertes à partir des valeurs d'étalonnage des moyens de court-circuitage et de mesure, ceci de manière à déterminer les valeurs d'impédance et/ou de pertes du transformateur de redresseur 20.

La figure 6 illustre un système de test 3 selon une possibilité envisageable de l'invention, dans laquelle le circuit de court-circuitage 50 est adapté pour mettre en court-circuitage chacune des branches positives du transformateur de redresseur 20 uniquement avec la branche négative correspondante, les dites branches positives et négatives. Ainsi le circuit de court-circuitage 50 selon cette possibilité envisageable se différencie d'un circuit de court-circuitage 50 selon le premier mode de réalisation en ce qu'il comporte trois branches de court-circuitage correspondant chacune à l'une des phases du transformateur de redresseur 20 et en ce que chacune des branches de court-circuitage comporte une unique diode. Ces branches de court-circuitage sont court-circuitées entre elles.

La diode de chacune des branches de court-circuitage du circuit de court-circuitage 50 est associée à la branche positive dudit transformateur de redresseur 20 pour n'autoriser le parcours du courant dans ladite branche de court-circuitage que dans un sens.

Dans ce mode de réalisation, le procédé de test se différencie de celui du premier mode de réalisation en ce que, lors de l'étape de court-circuitage, chaque branche positive est court-circuitée avec la branche négative correspondante en formant une branche de court-circuitage de manière à n'autoriser le parcours du courant entre une branche positive et une branche négative que dans un sens, ceci afin de mettre en saturation magnétique les transducteurs magnétiques 230a,b,c,d,e,f desdites branches positive et négative lors d'une mesure d'impédance et/ou de pertes, lesdites branches de court-circuitages étant court-circuitées entre elles.

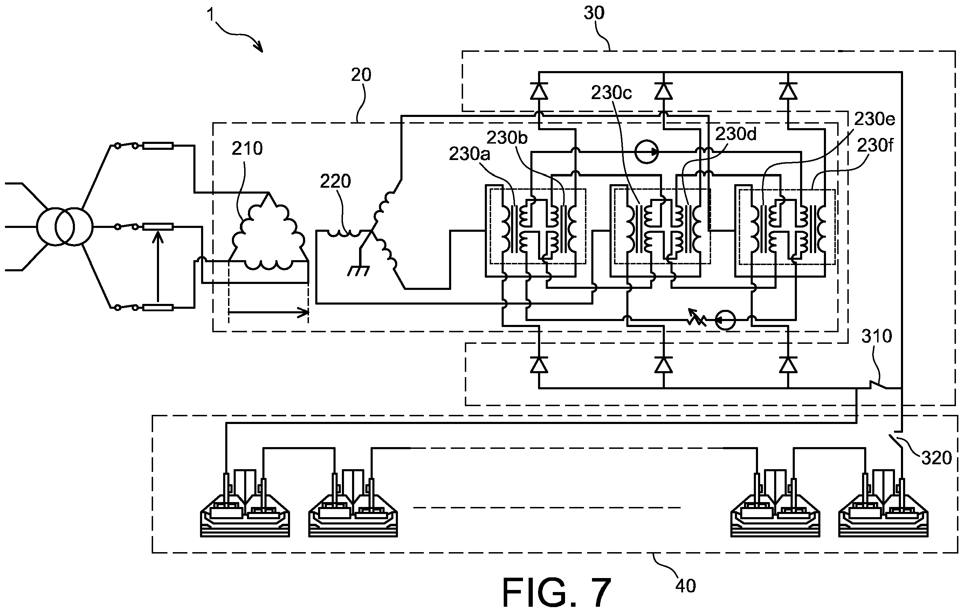

La figure 7 illustre un ensemble d'anodisation 1 selon un troisième mode de réalisation de l'invention dans lequel le circuit redresseur 30 présente une configuration dans laquelle il forme un circuit de court-circuitage selon l'invention. Un ensemble d'anodisation 1 selon ce troisième mode de réalisation se différencie d'un ensemble d'anodisation de l'art antérieur tel que précédemment décrit en ce que le circuit redresseur 30 comporte un interrupteur de court-circuitage agencé pour, lorsqu'il est en position fermée, court-circuiter le circuit redresseur 30 et un interrupteur d'isolation, agencé pour, lorsqu'il est en position ouverte, isoler le circuit redresseur 30 de l'installation 40.

Ainsi lorsque l'interrupteur d'isolation est en position fermée et l'interrupteur de court-circuitage est en position ouverte, l'ensemble d'anodisation 1 selon ce troisième mode fonctionne de manière similaire à l'ensemble d'anodisation 1 de l'art antérieur déjà décrit.

Lorsque l'interrupteur de court-circuitage est placé en position fermée et que l'interrupteur d'isolation est placé en position ouverte, le circuit redresseur 30 est dans une configuration dans laquelle il comporte pour chaque branche positive une branche de court-circuitage reliant ladite branche positive à la branche négative correspondante, chaque branche de court-circuitage étant configurée pour n'autoriser le parcours du courant dans ladite branche de court-circuitage que dans un sens. Dans cette même configuration, l'ensemble des branches de court-circuitage sont reliées entre elles de manière à mettre en court-circuit l'ensemble des branches positives du transformateur de redresseur 20 avec l'ensemble des branches négatives de ce même transformateur 20.

Dans une telle configuration, le circuit redresseur 30 forme un moyen de court-circuitage selon l'invention. De manière similaire au système électrique 2 illustré sur la figure 2, afin de réaliser un test du transformateur de redresseur 20, les bobinages primaires 210 peuvent être isolées du circuit d'alimentation 10 et reliées à un transformateur de test 60, tel que cela est illustré sur la figure 7. De cette manière, le circuit redresseur présente une configuration similaire à celle du circuit de court-circuitage 50 du premier mode de réalisation et permet donc la mise en œuvre d'un procédé de test similaire à celui décrit dans le premier mode de réalisation.

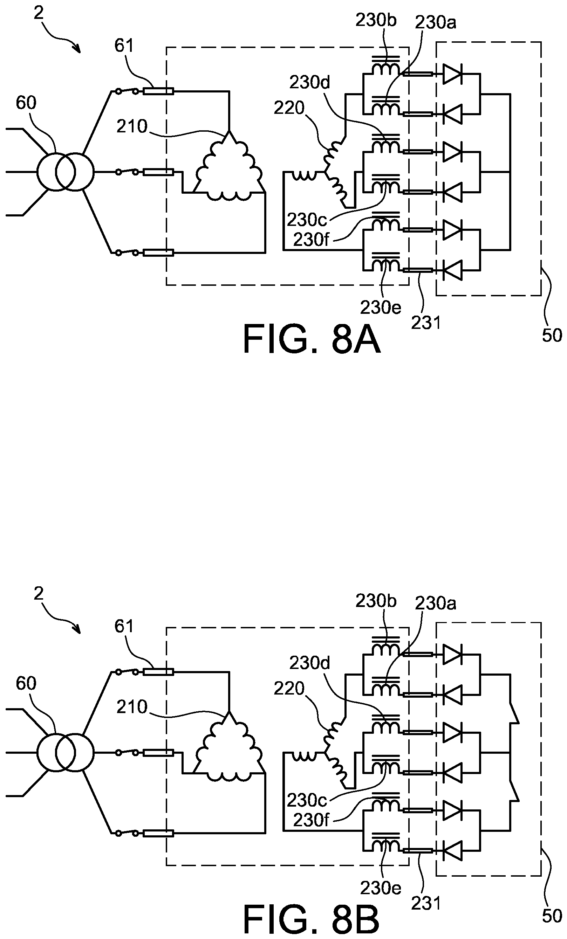

Les figures 8A à 8D illustrent des variantes de configuration du système de test illustré sur la figure 2 qui sont électriquement équivalentes à cette dernière.

La figure 8A, illustre une configuration monophasée dans laquelle, chacune des branches positives est directement en court-circuit avec la branche négative correspondante de manière à former ensemble une branche de court-circuitage. les branches de court-circuitages sont reliées entre elles de manière à ce que l'ensemble des branches positives soit mise en court-circuit avec l'ensemble des branches négatives.

La figure 8B illustre une configuration similaire dans laquelle il est prévu deux interrupteurs permettant d'isoler les branches de court-circuitages les unes des autres.

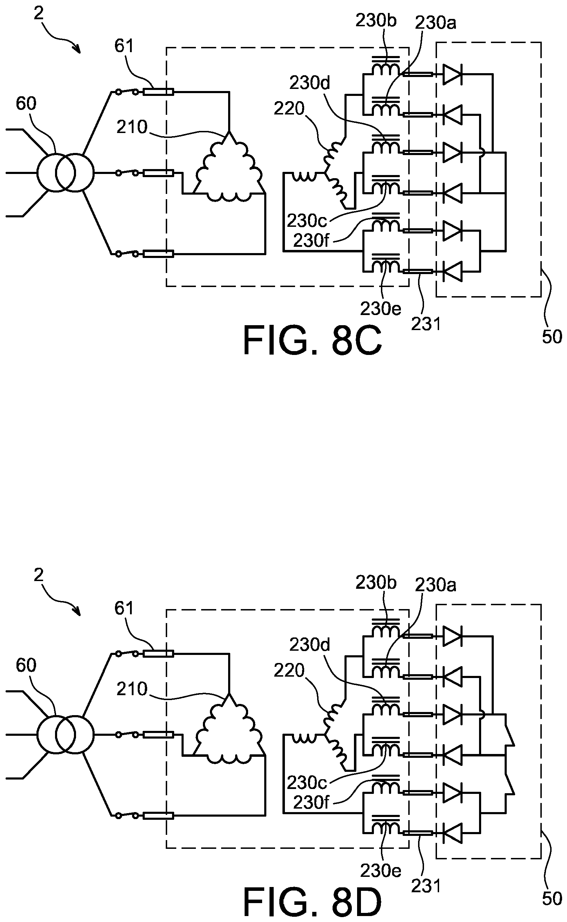

La figure 8C illustre une configuration hybride dans laquelle pour une phase la branche positive et négative correspondantes sont directement court-circuitées entre elles de manière à former une branche de court-circuitage selon une configuration monophasée. Les branches positives et négatives des deux autres phases étant respectivement reliées ensemble dans une configuration biphasée. Les deux branches de court-circuit positives et négatives ainsi formées sont toutes deux connectées à la branche de court-circuitage permettant ainsi que l'ensemble des branches positives soit mise en court-circuit avec l'ensemble des branches négatives.

La figure 8D illustre une configuration similaire à celle illustré figure 8C dans laquelle il est prévu deux interrupteurs permettant, lorsque les deux interrupteurs sont ouverts, d'isoler la branche de court-circuitage et les branches de court-circuit positive et négative les unes des autres.

## Revendications

**1.** Procédé de test d'un transformateur (20), dit de redresseur, destiné à être installé à l'interface entre un circuit d'alimentation (10) comportant au moins une phase, et une installation (40), telle qu'une installation comportant des cuves d'électrolyse d'aluminium, le transformateur de redresseur (20) comportant pour chaque phase du circuit d'alimentation un bobinage primaire (210) destiné à être relié à la phase correspondante du circuit d'alimentation (10) et un bobinage secondaire (220) destiné à être relié au travers d'un circuit redresseur (30) à l'installation (40) par une branche positive et une branche négative, chacune des branches positives et négative étant équipée d'un transducteur magnétique (230a,b,c,d,e,f), le procédé étant **caractérisé en ce qu'**il comporte les étapes consistant à :

- court-circuiter chaque branche positive avec la branche négative correspondante de manière à n'autoriser le parcours du courant entre une branche positive et une branche négative que dans un sens, ceci afin de mettre en saturation magnétique les transducteurs magnétiques (230a,b,c,d,e,f) desdites branches positive et négative lors d'une mesure d'impédance et/ou de pertes,
- effectuer une mesure d'impédance et/ou de pertes du transformateur de redresseur (20), les transducteurs magnétiques (230a,b,c,d,e,f) du transformateur étant en saturation magnétique grâce au court-circuitage.

**2.** Procédé de test selon la revendication 1, dans lequel le transformateur de redresseur (20) est installé à l'interface entre un circuit d'alimentation (10) comportant au moins deux phases, et une installation (40),
et dans lequel lors de l'étape de court-circuitage, l'ensemble des branches positives est mis en court-circuit avec l'ensemble des branches négatives.

**3.** Procédé de test selon la revendication 1 ou 2, dans lequel il est mis en œuvre un moyen de court-circuitage et un moyen de mesure, et dans lequel l'étape de mesure d'impédance comporte les sous-étapes suivantes :

- effectuer un étalonnage préalable des moyens de court-circuitage et de mesure de manière à déterminer des valeurs d'étalonnage desdits moyens de court-circuitage et de mesure,
- effectuer une mesure d'impédance et/ou de pertes, ceci avec le moyen de mesure,
- compenser la mesure d'impédance et/ou de pertes à partir des valeurs d'étalonnage des moyens de court-circuitage et de mesure, ceci de manière à déterminer les valeurs d'impédance et/ou de pertes du transformateur de redresseur (20).

**4.** Procédé de test selon l'une quelconque des revendications 1 à 3, dans lequel le transformateur de redresseur (20) installé à l'interface entre un circuit d'alimentation (10) comportant au moins une phase et une installation (40), l'étape de court-circuitage du transformateur de redresseur (20) consistant à court-circuiter le circuit redresseur (30) à travers lequel le transformateur de redresseur (20) est relié à l'installation, ceci de manière à n'autoriser le parcours du courant entre chaque branche positive et la branche négative correspondante que dans un sens.

5. Circuit de court-circuitage (50) pour un transformateur (20), dit de redresseur, le transformateur redresseur (20) étant destiné à être installé à l'interface entre un circuit d'alimentation (10) comportant au moins une phase, et une installation (40), telle qu'une installation comportant des cuves d'électrolyse d'aluminium, le transformateur de redresseur comportant pour chaque phase du circuit d'alimentation (10) un bobinage primaire (210) destiné à être relié à la phase correspondante du circuit d'alimentation (10) et un bobinage secondaire (220) destiné à être relié au travers d'un circuit redresseur (30) à l'installation (40) par une branche positive et une branche négative, chacune des branches positive et négative étant équipée d'un transducteur magnétique (230a,b,c,d,e,f),

le circuit de court-circuitage (50) **étant caractérisé en ce qu'**il comporte pour chaque branche positive du transformateur de redresseur (20) une branche de court-circuitage destinée à relier ladite branche positive à la branche négative correspondante, chaque branche de court-circuitage étant configurée de manière à n'autoriser le parcours du courant entre une branche positive et une branche négative que dans un sens, ceci afin de mettre en saturation magnétique les transducteurs magnétiques (230a,b,c, d,e,f) desdites branches positive et négative lors d'une mesure d'impédance.

6. Circuit de court-circuitage (50) pour un transformateur (20) selon la revendication 5, dans lequel le chaque branche de court-circuitage comporte au moins une diode dite positive destinée à être associée à la branche positive du transformateur de redresseur (20) pour n'autoriser le parcours du courant dans ladite branche de court-circuitage que dans un sens.

7. Circuit de court-circuitage (50) selon la revendication 6, dans lequel le circuit de court-circuitage (50) est destiné au test d'un transformateur de redresseur (20) installé à l'interface entre un circuit d'alimentation (10) comportant au moins deux phases et une installation (40), chacune des branches de court-circuitage du circuit de court-circuitage étant reliée entre elle de pour mettre l'ensemble des branches positives du transformateur de redresseur (20) en court-circuit avec l'ensemble des branches négatives, chacune des branches de court-circuitage comportant au moins une diode dite négative destinée à être associée à une branche négative du transformateur de redresseur (20) de manière à ce que la diode positive n'autorise le parcours du courant dans la branche positive que dans un sens et que la diode négative n'autorise le parcours du courant dans la branche négative que dans le sens opposé que celui de la diode positive.

8. Système électrique de test (2) comportant un transformateur (20), dit de redresseur, à tester, le transformateur de redresseur (20) étant destiné à être installé à l'interface entre un circuit d'alimentation (10) comportant au moins une phase, et une installation (40), telle qu'une installation comportant des cuves d'électrolyse d'aluminium, le transformateur de redresseur (20) comportant pour chaque phase du circuit d'alimentation un bobinage primaire (210) destiné à être relié à la phase correspondante du circuit d'alimentation (10) et un bobinage secondaire (220) destiné à être relié au travers d'un circuit redresseur (30) à l'installation (40) par une branche positive et une branche négative du transformateur de redresseur (20), chacune des branches positive et négative étant équipée d'un transducteur magnétique (230a,b,c,d,e,f), le système électrique de test (2) comportant :

   - un circuit de court-circuitage selon l'une quelconque des revendications 5 à 7, et
   - un moyen de mesure d'impédance adapté pour effectuer une mesure d'impédance du transformateur de redresseur (20), les transducteurs magnétiques du transformateur de redresseur (20) étant en saturation magnétique grâce au court-circuitage.

9. Ensemble d'anodisation (1) comportant une installation (40) d'anodisation d'aluminium, un circuit d'alimentation (10) alternatif, un transformateur (20), dit de redresseur, et un circuit redresseur (30), ledit transformateur de redresseur (20) étant installé à l'interface entre le circuit d'alimentation (10) et de l'installation (40), le transformateur de redresseur (20) comportant pour chaque phase du circuit d'alimentation un bobinage primaire (210) relié à la phase correspondante du circuit d'alimentation (10) et un bobinage secondaire (220) relié au travers du circuit redresseur (30) à l'installation (40) par une branche positive et une branche négative du transformateur de redresseur (20), chacune des branches positive et négative étant équipée d'un transducteur magnétique (230a,b,c,d,e,f),

le circuit redresseur présente une configuration dans laquelle il comporte pour chaque branche positive une branche de court-circuitage reliant ladite branche positive à la branche négative correspondante, chaque branche de court-circuitage étant configurée pour n'autoriser le parcours du courant dans ladite branche de court-circuitage que dans un sens, ledit circuit redresseur formant ainsi un circuit de court-circuitage selon l'une quelconque des revendications 5 à 7.

10. Ensemble d'anodisation (1) selon la revendication 9, dans lequel le circuit redresseur comporte un interrupteur de court-circuitage agencé pour, lorsqu'il est en position fermée, court-circuiter le circuit redresseur (30) et un interrupteur d'isolation, agencé pour, lorsqu'il est en position ouverte, isoler le circuit redresseur (30) de l'installation (40).

**Patentansprüche**

1. Prüfverfahren eines als Gleichrichter bezeichneten Transformators (20), der dazu bestimmt ist, an einer Schnittstelle zwischen einer Versorgungsschaltung (10), umfassend mindestens eine Phase, und einer Anlage (40), wie einer Anlage, die Aluminiumelektrolysewannen umfasst, installiert zu werden, wobei der Gleichrichtertransformator (20) für jede Phase der Versorgungsschaltung ein primäres Spulenbauteil (210), das dazu bestimmt ist, mit der entsprechenden Phase der Versorgungsschaltung (10) verbunden zu werden, und ein sekundäres Spulenbauteil (220) umfasst, das dazu bestimmt ist, mittels einer Gleichrichterschaltung (30) mit der Anlage (40) durch eine positive Verzweigung und eine negative Verzweigung verbunden zu werden, wobei jede der positiven und negativen Verzweigungen mit einem magnetischen Umformer (230a, b, c, d, e, f) ausgestattet ist, wobei das Verfahren **dadurch gekennzeichnet ist, dass** es die Schritte umfasst bestehend aus:

- Kurzschließen jeder positiven Verzweigung mit der entsprechenden negativen Verzweigung derart, um den Stromweg zwischen einer positiven Verzweigung und einer negativen Verzweigung ausschließlich in einer Richtung zu erlauben, damit die magnetischen Umformer (230a, b, c, d, e, f) der positiven und negativen Verzweigungen bei einer Impedanz- und/oder Verlustemessung magnetisch zu sättigen,
- Durchführen einer Impedanz- und/oder Verlustmessung des Gleichrichtertransformators (20), wobei die magnetischen Umformer (230a, b, c, d, e, f) des Transformators dank der Kurzschließung in magnetischer Sättigung vorliegen.

2. Prüfverfahren nach Anspruch 1, wobei der Gleichrichtertransformator (20) an der Schnittstelle zwischen einer Versorgungsschaltung (10), die mindestens zwei Phasen umfasst, und einer Anlage (40) installiert ist, und wobei bei dem Schritt des Kurzschließens die Gesamtheit der positiven Verzweigungen mit der Gesamtheit der negativen Verzweigungen in Kurzschluss gebracht wird.

3. Prüfverfahren nach Anspruch 1 oder 2, wobei ein Kurzschlussmittel und ein Messmittel eingesetzt wird, und wobei der Schritt des Messens der Impedanz die folgenden Unterschritte umfasst:

- Durchführen einer vorhergehenden Kalibrierung der Kurzschluss- und Messmittel derart, um Kalibrierungswerte der Kurzschluss- und Messmittel zu bestimmen,
- Durchführen einer Impedanz- und/oder Verlustemessung, dies mit dem Messmittel,
- Kompensieren der Impedanz- und/oder Verlustemessung ausgehend von Kalibrierungswerten der Kurzschluss- und Messmittel, dies derart, um die Impedanz- und/oder Verlustewerte des Gleichrichtertransformators (20) zu bestimmen.

4. Prüfverfahren nach einem der Ansprüche 1 bis 3, wobei der an der Schnittstelle zwischen einer Versorgungsschaltung (10), die mindestens eine Phase umfasst, und einer Anlage (40) installierte Gleichrichtertransformator (20), wobei der Schritt des Kurzschließens des Gleichrichtertransformators (20) im Kurzschließen der Gleichrichterschaltung (30) mittels der der Gleichrichtertransformator (20) mit der Anlage verbunden ist, besteht, dies derart, um den Stromweg zwischen jeder positiven Verzweigung und der entsprechenden negativen Verzweigung ausschließlich in einer Richtung zu erlauben.

5. Kurzschlussschaltung (50) für einen als Gleichrichter bezeichneten Transformator (20), wobei der Gleichrichtertransformator (20) dazu bestimmt ist, an einer Schnittstelle zwischen einer Versorgungsschaltung (10), umfassend mindestens eine Phase, und einer Anlage (40), wie einer Anlage von Aluminiumelektrolysewannen, installiert zu werden, wobei der Gleichrichtertransformator für jede Phase der Versorgungsschaltung (10) ein primäres Spulenbauteil (210), das dazu bestimmt ist, mit der entsprechenden Phase der Versorgungsschaltung (10) verbunden zu werden, und ein sekundäres Spulenbauteil (220) umfasst, das dazu bestimmt ist, durch eine positive Verzweigung und eine negative Verzweigung mittels einer Gleichrichterschaltung (30) mit der Anlage (40) verbunden zu werden, wobei jede der positiven und negativen Verzweigungen mit einem magnetischen Umformer (230a, b, c, d, e, f) ausgestattet ist

wobei die Kurzschlussschaltung (50) **dadurch gekennzeichnet ist, dass** sie für jede positive Verzweigung des Gleichrichtertransformators (20) eine Kurzschlussverzweigung umfasst, die dazu bestimmt ist, die positive Verzweigung mit der entsprechenden negativen Verzweigung zu verbinden, wobei jede Kurzschlussverzweigung derart konfiguriert ist, dass der Stromweg zwischen einer positiven Verzweigung und einer negativen Verzweigung ausschließlich in einer Richtung erlaubt ist, damit die magnetischen Umformer (230a, b, c, d, e, f) der positiven und negativen Verzweigungen bei der Impedanzmessung magnetisch gesättigt werden.

6. Kurzschlussschaltung (50) für einen Transformator (20) nach Anspruch 5, wobei die jede Kurzschlussverzweigung mindestens eine als positiv bezeichnete Diode umfasst, die dazu bestimmt ist, um mit der positiven Verzweigung des Gleichrichtertransformators (20) assoziiert zu werden, um den Stromweg in der Kurzschlussverzweigung ausschließlich in einer Richtung zu erlauben.

7. Kurzschlussschaltung (50) nach Anspruch 6, wobei die Kurzschlussschaltung (50) zur Prüfung eines an der Schnittstelle zwischen einer Versorgungsschaltung (10), die mindestens zwei Phasen umfasst, und einer Anlage (40) installierten Gleichrichtertransformators (20) bestimmt ist, wobei jede der Kurzschlussverzweigungen der Kurzschlussschaltung untereinander verbunden ist, um die Gesamtheit der positiven Verzweigungen des Gleichrichtertransformators (20) mit der Gesamtheit der negativen Verzweigungen in Kurzschluss zu bringen, wobei jede der Kurzschlussverzweigungen mindestens eine als negativ bezeichnete Diode umfasst, die dazu bestimmt ist, mit einer negativen Verzweigung des Gleichrichtertransformators (20) derart assoziiert zu sein, dass die positive Diode den Stromweg in der positiven Verzweigung ausschließlich in einer Richtung erlaubt und die negative Diode den Stromweg in der negativen Verzweigung ausschließlich in der der positiven Diode entgegengesetzten Richtung erlaubt.

8. Elektrisches Prüfsystem (2), umfassend einen als Gleichrichter bezeichneten zu prüfenden Transformator (20), wobei der Gleichrichtertransformator (20) dazu bestimmt ist, an der Schnittstelle zwischen einer Versorgungsschaltung (10), umfassend mindestens eine Phase, und einer Anlage (40), wie einer Anlage, die Aluminiumelektrolysewannen umfasst, installiert zu werden, wobei der Gleichrichtertransformator (20) für jede Phase der Versorgungsschaltung ein primäres Spulenbauteil (210), das dazu bestimmt ist, mit der entsprechenden Phase der Versorgungsschaltung (10) verbunden zu werden, und ein sekundäres Spulenbauteil (220) umfasst, das dazu bestimmt ist, mittels einer Gleichrichterschaltung (30) mit der Anlage (40) durch eine positive Verzweigung und eine negative Verzweigung des Gleichrichtertransformators (20) verbunden zu werden, wobei jede der positiven und negativen Verzweigungen mit einem magnetischen Umformer (230a, b, c, d, e, f) ausgestattet ist, wobei das elektrische Prüfsystem (2) umfasst:

- eine Kurzschlussschaltung nach einem der Ansprüche 5 bis 7 und
- ein Impedanzmessmittel, angepasst, um eine Impedanzmessung des Gleichrichtertransformators (20) durchzuführen, wobei die magnetischen Umformer des Gleichrichtertransformators (20) dank der Kurzschlussschaltung in magnetischer Sättigung vorliegen.

9. Anodisierungsbaugruppe (1), umfassend eine Anlage (40) zur Anodisierung von Aluminium, eine alternative Versorgungsschaltung (10), einen als Gleichrichter bezeichneten Transformator (20) und eine Gleichrichterschaltung (30), wobei der Gleichrichtertransformator (20) an der Schnittstelle zwischen der Versorgungsschaltung (10) und der Anlage (40) installiert ist, wobei der Gleichrichtertransformator (20) für jede Phase der Versorgungsschaltung ein mit der entsprechenden Phase der Versorgungsschaltung (10) verbundenes primäres Spulenbauteil (210) und ein durch eine positive Verzweigung und eine negative Verzweigung des Gleichrichtertransformators (20) mittels der Gleichrichterschaltung (30) mit der Anlage (40) verbundenes sekundäres Spulenbauteil (220) umfasst, wobei jede der positiven und negativen Verzweigungen mit einem magnetischen Umformer (230a, b, c, d, e, f) ausgestattet ist, wobei die Gleichrichterschaltung eine Konfiguration aufweist, in der sie für jede positive Verzweigung eine Kurzschlussverzweigung aufweist, die die positive Verzweigung mit der entsprechenden negativen Verzweigung verbindet, wobei jede Kurzschlussverzweigung konfiguriert ist, um den Stromweg in der Kurzschlussverzweigung ausschließlich in einer Richtung zu erlauben, wobei die Kurzschlussschaltung somit eine Kurzschlussschaltung nach einem der Ansprüche 5 bis 7 bildet.

10. Anodisierungsbaugruppe (1) nach Anspruch 9, wobei die Gleichrichterschaltung einen Kurzschlussschalter, angeordnet, um, wenn er in geschlossener Position vorliegt, die Gleichrichterschaltung (30) kurzzuschließen, und einen Trennschalter umfasst, angeordnet, um, wenn er in geöffneter Position vorliegt, die Gleichrichterschaltung (30) von der Anlage (40) zu trennen.

**Claims**

1. Method for testing a so-called rectifier transformer (20) intended to be installed at the interface between a power supply circuit (10) including at least one phase, and a plant (40), such as a plant including aluminium electrolysis tanks, the rectifier transformer (20) including, for each phase of the power supply circuit, a primary winding (210) intended to be connected to the corresponding phase of the power supply circuit (10) and a secondary winding (220) intended to be connected through a rectifier circuit (30) to the plant (40) by a positive arm and a negative arm, each of the positive and negative arms being equipped with a magnetic transducer (230a, b, c, d, e, f), the method being **characterised in that** it includes the steps consisting in:

- short-circuiting each positive arm with the corresponding negative arm so as to allow travel of the current between a positive arm and a negative arm only in one direction, in order to put the magnetic transducers (230a, b, c, d, e, f) of said positive and negative arms in magnetic saturation during a measurement of impedance and/or of losses,
- making a measurement of impedance and/or of losses of the rectifier transformer (20), the magnetic transducers (230a, b, c, d, e, f) of the transformer being in magnetic saturation by virtue of the short-circuiting.

2. Test method according to claim 1, wherein the rectifier transformer (20) is installed at the interface between a power supply circuit (10) including at least two phases, and a plant (40), and wherein, during the short-circuiting step, all the positive arms are shortcircuited with all the negative arms.

3. Test method according to claim 1 or 2, wherein a short-circuiting means and a measurement means are used, and wherein the impedance-measurement step includes the following substeps:

- implementing a prior calibration of the short-circuiting and measurement means so as to determine calibration values of said short-circuiting and measurement means,
- making a measurement of impedance and/or of losses, with the measurement means,
- compensating for the measurement of impedance and/or of losses using the calibration values of the short-circuiting and measurement means, so as to determine the impedance and/or loss values of the rectifier transformer (20).

4. Test method according to any one of claims 1 to 3, wherein the rectifier transformer (20) installed at the interface between a power supply circuit (10) including at least one phase and a plant (40), the step of short-circuiting the rectifier transformer (20) consisting in short-circuiting the rectifier circuit (30) through which the rectifier transformer (20) is connected to the plant, so as to allow the travel of the current between each positive arm and the corresponding negative arm only in one direction.

5. Short-circuiting circuit (50) for a so-called rectifier transformer (20) the rectifier transformer (20) being intended to be installed at the interface between a power supply circuit (10) including at least one phase, and a plant (40), such as a plant including aluminium electrolysis tanks, the rectifier transformer (20) including, for each phase of the power supply circuit, a primary winding (210) intended to be connected to the corresponding phase of the power supply circuit (10) and a secondary winding (220) intended to be connected through a rectifier circuit (30) to the plant (40) by a positive arm and a negative arm, each of the positive and negative arms being equipped with a magnetic transducer (230a, b, c, d, e, f),
the short-circuiting circuit (50) **being characterised in that** it includes, for each positive arm of the rectifier transformer (20), a short-circuiting arm intended to connect said positive arm to the corresponding negative arm, each short-circuiting arm being configured so as to allow the current to pass between a positive arm and a negative arm only in one direction, in order to put the magnetic transducers (230a, b, c, d, e, f) of said positive and negative arms in magnetic saturation during an impedance measurement.

6. Short-circuiting circuit (50) for a transformer (20) according to claim 5, wherein the each short-circuiting arm includes at least one so-called positive diode intended to be associated with the positive arm of the rectifier transformer (20) to allow travel of the current in said short-circuiting arm only in one direction.

7. Short-circuiting circuit (50) according to claim 6, wherein the short-circuiting circuit (50) is intended for testing a rectifier transformer (20) installed at the interface between a power supply circuit (10) including at least two phases and a plant (40), each of the short-circuiting arms of the short-circuiting circuit being connected together so as to put all the positive arms of the rectifier transformer (20) in short-circuit with all the negative arms, each of the short-circuiting arms including at least one so-called negative diode intended to be associated with a negative arm of the rectifier transformer (20) so that the positive diode allows travel of the current in the positive arm only in one direction and so that the negative diode allows travel of the current in the negative arm only in the direction opposite to that of the positive diode.

8. Electrical test system (2) including a so-called rectifier transformer (20) to be tested, the rectifier transformer (20) being intended to be installed at the interface between a power supply circuit (10) including at least one phase, and a plant (40), such as a plant including aluminium electrolysis tanks, the rectifier transformer (20) including, for each phase of the power supply circuit, a primary winding (210) intended to be connected to the corresponding phase of the power supply circuit (10) and a secondary winding (220) intended to be connected through a rectifier circuit (30) to the plant (40) by a positive arm and a negative arm of the rectifier transformer (20), each of the positive and negative arms being equipped with a magnetic transducer (230a, b, c, d, e, f), the electrical test system (2) including:

  - a short-circuiting circuit according to any one of claims 5 to 7, and
  - an impedance measurement means adapted for making a measurement of impedance of the rectifier transformer (20), the magnetic transducers of the rectifier transformer (20) being in magnetic saturation by virtue of the short-circuiting.

9. Anodisation assembly (1) including an aluminium-anodisation plant (40), an alternating power supply circuit (10), a so-called rectifier transformer (20) and a rectifier circuit (30), said rectifier transformer (20) being installed at the interface between the power supply circuit (10) and the plant (40), the rectifier transformer (20) including, for each phase of the power supply circuit, a primary winding (210) connected to the corresponding phase of the power supply circuit (10) and a secondary winding (220) connected through the rectifier circuit (30) to the plant (40) by a positive arm and a negative arm of the rectifier transformer (20), each of the positive and negative arms being equipped with a magnetic transducer (230a, b, c, d, e, f), the rectifier circuit has a configuration wherein it includes, for each positive arm, a short-circuiting arm connecting said positive arm to the corresponding negative arm, each short-circuiting arm being configured to allow travel of the current in said short-circuiting arm only in one direction, said rectifier circuit thus forming a short-circuiting circuit according to any one of claims 5 to 7.

10. Anodisation assembly (1) according to claim 9, wherein the rectifier circuit includes a short-circuiting switch arranged to, when it is in the closed position, short-circuit the rectifier circuit (30) and an isolation switch, arranged to, when it is in the open position, isolate the rectifier circuit (30) from the plant (40).

FIG. 1

EP 3 123 187 B1

FIG. 2

FIG. 3

FIG. 4

FIG. 5

FIG. 6

FIG. 7

EP 3 123 187 B1

FIG. 8A

FIG. 8B

FIG. 8C

FIG. 8D

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2970109